# EUROPEAN PATENT SPECIFICATION

(11) **EP 2 315 728 B1**
(45) Date of publication and mention of the grant of the patent: **24.04.2013**
(21) Application number: 09759596.1
(22) Date of filing: 08.06.2009
(51) Int. Cl.: C03C 3/064, C03C 3/066, C03C 3/07, C03C 3/072, C03C 3/074, C03C 3/14, C03C 8/04, C03C 8/10, C03C 8/12, C03C 8/14, C03C 8/18, C03C 8/20, C03C 10/00, C03C 14/00, H01B 1/16

(54) **GLASS COMPOSITIONS USED IN CONDUCTORS FOR PHOTOVOLTAIC CELLS**
-
COMPOSITIONS DE VERRE UTILISÉES DANS DES CONDUCTEURS POUR CELLULES PHOTOVOLTAÏQUES

(30) Priority: 26.06.2008 US 75826; 08.07.2008 US 78888; 21.10.2008 US 107035; 12.11.2008 US 113701; 23.12.2008 US 140235; 09.06.2008 US 143525; 05.02.2009 US 150044
(43) Date of publication of application: 04.05.2011
(73) Proprietor: E. I. du Pont de Nemours and Company, Wilmington, DE 19898 (US)
(72) Inventor: KONNO, Takuya, Kawasaki-shi Kanagawa 213/0012 (JP); LAUGHLIN, Brian, J., Apex NC 27539 (US); MATSUNO, Hisashi, Setagaya-ku Tokyo (JP)
(74) Representative: Hoffmann, Benjamin
(86) International application number: PCT/US2009/046573
(87) International publication number: WO 2009/149438

(56) References cited:
- EP-A1- 1 298 099
- EP-A1- 1 993 144
- EP-A1- 2 200 091
- WO-A2-2010/123967
- DE-A1- 10 116 653
- JP-A- 2000 090 733
- JP-A- 2005 174 683
- JP-A- 2007 246 311
- US-A1- 2006 001 009
- US-A1- 2007 215 202

## Description

### CROSS REFERENCES TO RELATED APPLICATIONS

This application claims priority under 35 U.S.C. 119(e) to the following U.S. Provisional Application Numbers:
61/075826, filed June 26, 2008
61/078888, filed July 8, 2008
61/107035, filed October 21, 2008
61/113701, filed November 12, 2008
61/140235, filed December 23, 2008
61/143525, filed January 9, 2009
61/150044, filed February 5, 2009

### FIELD OF THE INVENTION

Embodiments of the invention relate to a silicon semiconductor device, and a conductive silver paste containing glass frit for use in a solar cell device.

### TECHNICAL BACKGROUND OF THE INVENTION

A conventional solar cell structure with a p-type base has a negative electrode that may be on the front-side or sun side of the cell and a positive electrode that may be on the opposite side. Radiation of an appropriate wavelength falling on a p-n junction of a semiconductor body serves as a source of external energy to generate hole-electron pairs in that body. Because of the potential difference which exists at a p-n junction, holes and electrons move across the junction in opposite directions and thereby give rise to flow of an electric current that is capable of delivering power to an external circuit. Most solar cells are in the form of a silicon wafer that has been metalized, i.e., provided with metal contacts that are electrically conductive.

There is a need for compositions, structures (for example, semiconductor, solar cell or photodiode structures), and semiconductor devices (for example, semiconductor, solar cell or photodiode devices) which have improved electrical performance, and methods of making.

### SUMMARY OF THE INVENTION

An embodiment of the invention relates to a composition including:
(a) one or more electrically conductive materials, (b) one or more glass frits which include 7-25 wt% of SiO₂, 55-90 wt% of Bi₂O₃, 0.5-5 wt% of B₂O₃, 1.5 to 8 wt % of one or more alkali metal oxides; 1-8 wt% of ZrO₂; and organic medium. In an aspect of this embodiment, the composition may include 11 - 25 wt% of SiO₂. In an aspect, the alkali metal oxides may be selected from the group consisting of: Na₂O, Li₂O, and mixtures thereof. The composition may further include one or more additives selected from the group consisting of: (a) a metal wherein said metal is selected from Zn, Pb, Bi, Gd, Ce, Zr, Ti, Mn, Sn, Ru, Co, Fe, Cu, and Cr;
(b) a metal oxide of one or more of the metals selected from Zn, Pb, Bi, Gd, Ce, Zr, Ti, Mn, Sn, Ru, Co, Fe, Cu and Cr; (c) any compounds that can generate the metal oxides of (b) upon firing; and (d) mixtures thereof.

Another aspect of the invention relates to a method of manufacturing a semiconductor device including the steps of: (a) providing a semiconductor substrate, one or more insulating films, and the thick film composition: (b) applying the insulating film to the semiconductor substrate, (c) applying the thick film composition to the insulating film on the semiconductor substrate, and (d) firing the semiconductor, insulating film and thick film composition.

Another aspect of the invention relates to a solar cell including a semiconductor device including a semiconductor substrate, an insulating film, and an electrode, wherein the front-side electrode includes glass frit containing 7-25 wt% of SiO₂, 55-90 wt% of Bi₂O₃, 0.5-5 wt% of B₂O₃, 1.5 to 8 wt % of one or more alkali metal oxides; 1-8 wt% of ZrO₂.

### DETAILED DESCRIPTION OF THE INVENTION

The thick film conductor compositions described herein include one or more electrically functional powders and one or more glass frits dispersed in an organic medium. The thick film compositions may also include one or more additive(s). Exemplary additives may include metals, metal oxides or any compounds that can generate these metal oxides during firing. An aspect of the invention relates to one or more glass frits useful in thick film conductor composition(s). In an embodiment, these thick film conductor composition(s) are for use in a semiconductor device. In an aspect of this embodiment, the semiconductor device maybe a solar cell or a photodiode. An embodiment relates to a broad range of semiconductor devices. An embodiment relates to light-receiving elements such as photodiodes and solar cells.

### Glass frits

An embodiment relates to glass frit compositions (also termed glass frits, or glass compositions herein). Exemplary glass frit compositions are listed in Tables 1-4 below. The glass compositions listed in Tables 1-4 are not limiting. It is contemplated that one of ordinary skill in the art of glass chemistry could make minor substitutions of additional ingredients and not substantially change the desired properties of the glass composition of this invention. For example, substitutions of glass formers such as P₂O₅ 0-3, GeO₂ 0-3, V₂O₅ 0-3 in weight % may be used either individually or in combination to achieve similar performance. For example, one or more intermediate oxides, such as TiO₂, Ta₂O₅, Nb₂O₅, ZrO₂, CeO₂, and SnO₂ may be substituted for other intermediate oxides (i.e., Al₂O₃, CeO₂, SnO₂) present in a glass composition of this invention.

An exemplary method for producing the glass frits described herein is by conventional glass making techniques. Ingredients are weighed then mixed in the desired proportions and heated in a furnace to form a melt in platinum alloy crucibles. As well known in the art, heating is conducted to a peak temperature (80-140°C) and for a time such that the melt becomes entirely liquid and homogeneous. The molten glass is then quenched between counter rotating stainless steel rollers to form a 254-381 µm (10-15 mil) thick platelet of glass. The resulting glass platelet was then milled to form a powder with its 50% volume distribution set between to a desired target (e.g. 0.8 - 1.5 µm). One skilled in the art may employ alternative synthesis techniques such as but not limited to water quenching, sol-gel, spray pyrolysis, or others appropriate for making powder forms of glass.

In a further embodiment, the glass frit may include a glass-ceramic where the remnant glass after ceramming may have a specific chemistry.

An embodiment relates to lead-free glass frits. Exemplary embodiments related to the glass compositions, in weight percent total glass composition, are shown in Table 3. These glass frit compositions were made according to methods described herein. In aspects of this embodiment, the: SiO₂ is 7 to 25 wt%, 15 to 24 wt%, or 20 to 22 wt%, Al₂O₃ may be 0 to 1 wt%, 0 to 0.3 wt%, or 0.1 to 0.3 wt%, B₂O₃ is 0.5 to 5 wt%, 0.8 to 4.5 wt%, or 3 to 4 wt%, Na₂O may be 0.1 to 4 wt%, 0.5 to 3 wt%, or 1.5 to 2.5 wt%, Li₂O may be 0.1 to 4 wt%, 0.5 to 3 wt%, or, 1.5 to 2.5 wt%. ZrO₂ is 1 to 8 wt%, 1.25 to 6wt%, or 4 to 5 wt%, Bi₂O₃ is 55 to 90 wt%, 60 to 80 wt%, or 60 to 70 wt%, TiO₂ may be 0 to 5 wt%, 0 to 3 wt%, or 1.5 to 2.5 wt%, based on the weight percent of the total glass composition.

One skilled the art of making glass could replace some or all of the Na₂O or Li₂O with K₂O, Cs₂O, or Rb₂O and create a glass with properties similar to the compositions listed above where this embodiment the total alkali metal oxide content is 1.5 to 8 wt%, or 4 to 5 wt%

In a further embodiment, the glass frit composition(s) herein may include one or more of an additional set of components: CeO₂, SnO₂, Ga₂O₃, In₂O₃, NiO, MoO₃, WO₃, Y₂O₃, La₂O₃, Nd₂O₃, FeO, HfO₂, Cr₂O₃, CdO, Nb₂O₅, Ag₂O, Sb₂O₃, and metal halides (e.g. NaCl, KBr, Nal).

One of skill in the art would recognize that the choice of raw materials could unintentionally include impurities that may be incorporated into the glass during processing. For example, the impurities may be present in the range of hundreds to thousands ppm.

In an embodiment, the composition may include less than 1.0 wt% of inorganic additive, based on the wt % of the total composition. In an embodiment, the composition may include less than 0.5 wt% of inorganic additive, based on the wt % of the total composition. In a further embodiment, the composition may not include an inorganic additive. In an embodiment, the glass frit mentioned herein may have a softening point between 500-600 °C.

**Table 3: Glass Compositions in weight percent (wt%)**

| ID # | SiO₂ | Al₂O₃ | B₂O₃ | Na₂O | Li₂O | ZrO₂ | Bi₂O₃ | TiO₂ |
|---|---|---|---|---|---|---|---|---|
| 31 | 16.36 | - | 1.92 | 1.20 | 1.20 | 2.71 | 76.62 | - |
| 32 | 11.28 | - | 1.32 | 0.94 | 0.94 | 1.87 | 83.65 | - |
| 33 | 7.66 | - | 0.90 | 0.79 | 0.79 | 1.27 | 88.60 | - |
| 34 | 21.02 | - | 3.70 | 2.31 | 2.31 | 5.23 | 65.43 | - |
| 35 | 21.90 | 0.25 | 3.80 | 1.60 | 1.50 | 4.10 | 64.85 | 2.0 |

The amount of glass frit in the total composition is in the range of .1 to 10 wt % of the total composition. In one embodiment, the glass composition is present in the amount of 1 to 8 wt % of the total composition. In a further embodiment, the glass composition is present in the range of 4 to 6 wt % of the total composition.

**Table 4: Glass Compositions in weight percent (wt%)**

| ID # | SiO₂ | Al₂O₃ | PbO | B₂O₃ | CaO | ZnO | MgO | Na₂O | FeO | Li₂O | ZrO₂ | Bi₂O₃ | TiO₂ |
|---|---|---|---|---|---|---|---|---|---|---|---|---|---|
| 68 | 12.2 | 0.3 | - | 4.2 | - | - | - | 2.4 | - | 2.3 | 4.7 | 71.6 | 2.2 |

### Conductive powder

In an embodiment, the thick film composition may include a functional phase that imparts appropriate electrically functional properties to the composition. The functional phase comprises electrically functional powders dispersed in an organic medium that acts as a carrier for the functional phase that forms the composition. The composition is fired to burn out the organic phase, activate the inorganic binder phase and to impart the electrically functional properties. In an embodiment, the electrically functional powder may be a conductive powder.

In an embodiment, the conductive powder may include Ag. In a further embodiment, the conductive powder may include silver (Ag) and aluminum(Al). In a further embodiment, the conductive powder may, for example, include one or more of the following: Cu, Au, Ag, Pd, Pt, Al, Ag-Pd, Pt-Au, etc. In an embodiment, the conductive powder may include one or more of the following: (1) Al, Cu, Au, Ag, Pd and Pt; (2) alloy of Al, Cu, Au, Ag, Pd and Pt; and (3) mixtures thereof.

In an embodiment, the functional phase of the composition may include coated or uncoated silver particles which are electrically conductive. In an embodiment in which the silver particles are coated, they may be at least partially coated with a surfactant. In an embodiment, the surfactant may include one or more of the following non-limiting surfactants: stearic acid, palmitic acid, a salt of stearate, a salt of palmitate, lauric acid, palmitic acid, oleic acid, stearic acid, capric acid, myristic acid and linoleic acid, and mixtures thereof. The counter ion may be, but is not limited to, hydrogen, ammonium, sodium, potassium and mixtures thereof.

The particle size of the silver is not subject to any particular limitation. In an embodiment, the average particle size may be less than 10 microns, and, in a further embodiment, no more than 5 microns. In an aspect, the average particle size may be 0.1 to 5 microns, for example. In an embodiment, the silver powder may be 70 to 85 wt % of the paste composition. In a further embodiment, the silver may be 90 to 99 wt % of the solids in the composition (i.e., excluding the organic vehicle).

### Additives

In an embodiment, the thick film composition may include an additive. In an embodiment, the composition may not include an additive. In an embodiment, the additive may be selected from one or more of the following: (a) a metal wherein said metal is selected from Zn, Pb, Bi, Gd, Ce, Zr, Ti, Mn, Sn, Ru, Co, Fe, Cu, and Cr; (b) a metal oxide of one or more of the metals selected from Zn, Pb, Bi, Gd, Ce, Zr, Ti, Mn, Sn, Ru, Co, Fe, Cu and Cr; (c) any compounds that can generate the metal oxides of (b) upon firing; and (d) mixtures thereof.

In an embodiment, the additive may include a Zn-containing additive. The Zn-containing additive may include one or more of the following: (a) Zn, (b) metal oxides of Zn, (c) any compounds that can generate metal oxides of Zn upon firing, and (d) mixtures thereof. In an embodiment, the Zn-containing additive may include Zn resinate.

In an embodiment, the Zn-containing additive may include ZnO. The ZnO may have an average particle size in the range of 10 nanometers to 10 microns. In a further embodiment, the ZnO may have an average particle size of 40 nanometers to 5 microns. In a further embodiment, the ZnO may have an average particle size of 60 nanometers to 3 microns. In a further embodiment the ZnO may have an average particle size of less than 1- nm; less than 90 nm; less than 80 nm; 1 nm to less than 1- nm; 1 nm to 95 nm; 1 nm to 90 nm; 1 nm to 80 nm; 7 nm to 30 nm; 1 nm to 7 nm; 35 nm to 90 nm; 35 nm to 80 nm, 65 nm to 90nm, 60 nm to 80 nm, and ranges in between, for example.

In an embodiment, ZnO may be present in the composition in the range of 2 to 10 weight percent total composition. In an embodiment, the ZnO may be present in the range of 4 to 8 weight percent total composition. In a further embodiment, the ZnO may be present in the range of 5 to 7 weight percent total composition. In a further embodiment, the ZnO may be present in the range of greater than 4.5 wt %, 5 wt %, 5.5 wt %, 6 wt %, 6.5 wt %, 7 wt %, or 7.5 wt % of the total composition.

In a further embodiment the Zn-containing additive (for example Zn, Zn resinate, etc.) may be present in the total thick film composition in the range of 2 to 16 weight percent. In a further embodiment the Zn-containing additive may be present in the range of 4 to 12 weight percent total composition. In a further embodiment, the Zn-containing additive may be present in the range of greater than 4.5 wt %, 5 wt %, 5.5 wt %, 6 wt %, 6.5 wt %, 7 wt %, or 7.5 wt % of the total composition.

In one embodiment, the particle size of the metal/metal oxide additive (such as Zn, for example) is in the range of 7 nanometers (nm) to 125 nm; in a further embodiment, the particle size may be less than 1- nm, 90 nm, 85 nm, 80 nm, 75 nm, 70 nm, 65 nm, or 60 nm, for example.

### Organic Medium

In an embodiment, the thick film compositions described herein may include organic medium. The inorganic components may be mixed with an organic medium, for example, by mechanical mixing to form viscous compositions called "pastes", having suitable consistency and rheology for printing. A wide variety of inert viscous materials can be used as organic medium. In an embodiment, the organic medium may be one in which the inorganic components are dispersible with an adequate degree of stability. In an embodiment, the rheological properties of the medium may lend certain application properties to the composition, including: stable dispersion of solids, appropriate viscosity and thixotropy for screen printing, appropriate wettability of the substrate and the paste solids, a good drying rate, and good firing properties. In an embodiment, the organic vehicle used in the thick film composition may be a nonaqueous inert liquid. The use of various organic vehicles, which may or may not contain thickeners, stabilizers and/or other common additives, is contemplated. The organic medium may be a solution of polymer(s) in solvent(s). In an embodiment, the organic medium may also include one or more components, such as surfactants. In an embodiment, the polymer may be ethyl cellulose. Other exemplary polymers include ethylhydroxyethyl cellulose, wood rosin, mixtures of ethyl cellulose and phenolic resins, polymethacrylates of lower alcohols, and monobutyl ether of ethylene glycol monoacetate, or mixtures thereof. In an embodiment, the solvents useful in thick film compositions described herein include ester alcohols and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In a further embodiment, the organic medium may include volatile liquids for promoting rapid hardening after application on the substrate.

In an embodiment, the polymer may be present in the organic medium in the range of 5 to 20 wt %; or 8 wt. % to 11 wt% of the organic medium, for example. The composition may be adjusted by one of ordinary skill in the art to a predetermined, screen-printable viscosity with the organic medium.

In an embodiment, the ratio of organic medium in the thick film composition to the inorganic components in the dispersion may be dependent on the method of applying the paste and the kind of organic medium used, as determined by one of skill in the art. In an embodiment, the dispersion may include 70-95 wt % of inorganic components and 5-30 wt % of organic medium (vehicle) in order to obtain good wetting.

### Description of Method of Manufacturing a Semiconductor Device

An embodiment of the invention relates to thick film composition(s) that may be utilized in the manufacture of a semiconductor device. The semiconductor device may be manufactured by the following method from a structural element composed of a junction-bearing semiconductor substrate and a silicon nitride insulating film formed on a main surface thereof. The method of manufacture of a semiconductor device includes the steps of applying (such as coating and printing) onto the insulating film, in a predetermined shape and at a predetermined position, the composition having the ability to penetrate the insulating film, then firing so that the conductive thick film composition melts and passes through the insulating film, effecting electrical contact with the silicon substrate.

An embodiment of the invention relates to a semiconductor device manufactured from the methods described herein.

In an embodiment, the insulating film may include a silicon nitride film or silicon oxide film. The silicon nitride film may be formed by a plasma chemical vapor deposition (CVD) or thermal CVD process. The silicon oxide film may be formed by thermal oxidation, thermal CFD or plasma CFD.

In an embodiment, the method of manufacture of the semiconductor device may also be characterized by manufacturing a semiconductor device from a structural element composed of a junction-bearing semiconductor substrate and an insulating film formed on one main surface thereof, wherein the insulating layer is selected from a titanium oxide silicon nitride, SiNx:H, silicon oxide, and silicon oxide/titanium oxide film, which method includes the steps of forming on the insulating film, in a predetermined shape and at a predetermined position, a metal paste material having the ability to react and penetrate the insulating film, forming electrical contact with the silicon substrate. The titanium oxide film may be formed by coating a titanium-containing organic liquid material onto the semiconductor substrate and firing, or by a thermal CVD. The silicon nitride film is typically formed by PECVD (plasma enhanced chemical vapor deposition). An embodiment of the invention relates to a semiconductor device manufactured from the method described above.

In an embodiment, the composition may be applied using printing techniques know to one of skill in the art such as screen-printing, for example.

In an embodiment, the electrode formed from the conductive thick film composition(s) may be fired in an atmosphere composed of a mixed gas of oxygen and nitrogen. This firing process removes the organic medium and sinters the glass frit with the Ag powder in the conductive thick film composition. The semiconductor substrate may be single-crystal or multicrystalline silicon, for example.

Additional substrates, devices, methods of manufacture, and the like, which may be utilized with the thick film compositions described herein are described in US patent application publication numbers US 2006/0231801, US 2006/0231804, and US 2006/0231800 .

The presence of the impurities would not alter the properties of the glass, the thick film composition, or the fired device. For example, a solar cell containing the thick film composition may have the efficiency described herein, even if the thick film composition includes impurities.

In a further aspect of this embodiment, thick film composition may include electrically functional powders and glass-ceramic frits dispersed in an organic medium. In an embodiment, these thick film conductor composition(s) may be used in a semiconductor device. In an aspect of this embodiment, the semiconductor device may be a solar cell or a photodiode.

### EXAMPLES

Used materials in the paste preparation and the contents of each component are as follows.

### Glass Property Measurement

The glass frit compositions outlined in Table 3 were characterized to determine density, softening point, TMA shrinkage, diaphaneity, and crystallinity. Each glass frit powder in Table 3 was combined with organic vehicle to make a thick film paste that was printed on a crystalline silicon with an insulating film, fired, and then viewed in cross-section to evaluate the ability of the frit to react and penetrate the insulating film. Additionally, pellets of frit were fired on substrates (for example, glass, alumina, silicon nitride, silicon, and/or silver foil) to evaluate their flow characterizes on these substrates.

### Paste Preparation

Paste preparations, in general, were accomplished with the following procedure: The appropriate amount of solvent, medium and surfactant were weighed then mixed in a mixing can for 15 minutes, then glass frits described herein, and optionally metal additives, were added and mixed for another 15 minutes. Since Ag is the major part of the solids of the composition, it was added incrementally to ensure better wetting. When well mixed, the paste was repeatedly passed through a 3-roll mill for at progressively increasing pressures from 27 kPa (0 to 4- psi.) The gaps of the rolls were adjusted to (25.4 µm) (1 mil.) The degree of dispersion was measured by fineness of grind (FOG). A typical FOG value is generally equal to or less than 20/10 for conductors.

### Test Procedure Efficiency and results

### Test Procedure of FF and results

The electrical characteristics (I-V characteristics) of the resulting solar cell substrate with an electrode containing glass ID#31-34 and ID#35 which was a conventional glass composition were evaluated using a model NCT-M-150AA cell tester manufactured by NPC Co. Current-voltage curve (I-V curve) was made with the results of the measurement to calculate Fill factor (FF value). In general, the higher FF value indicates the better electrical generation property in a solar cell. The electrodes formed with glass frit of #31-34 obtained higher FF than that of #35.

The above efficiency test is exemplary. Other equipment and procedures for testing efficiencies were recognized by one of ordinary skill in the art.

**Table 7**

| ID # | FF |
|---|---|
| 31 | 0.74 |
| 32 | 0.55 |
| 33 | 0.54 |
| 34 | 0.76 |
| 35 | 0.41 |

## Claims

1. A composition comprising:
(a) one ore more electrically conductive materials;
(b) one or more glass frits, wherein one or more of the glass frits comprises, based on the wt % of the glass frit:
7-25 wt% of SiO₂,
55-90 wt% of Bi₂O₃,
0.5-5 wt% of B₂O₃,
1.5 - 8 wt% of one or more alkali metal oxides;
1-8 wt% of ZrO₂; and
(c) organic medium.

2. The composition of claim 1, wherein one or more of the glass frits comprises 11-25 wt% of SiO₂.

3. The composition of claim 1, wherein the alkali metal oxides are selected from the group consisting of: Na₂O, Li₂O, and mixtures thereof.

4. The composition of claim 1 wherein the softening point of the glass frit is 500-600 °C.

5. The composition of claim 1, further comprising one or more additives selected from the group consisting of: (a) a metal wherein said metal is selected from Zn, Pb, Bi, Gd, Ce, Zr, Ti, Mn, Sn, Ru, Co, Fe, Cu, and Cr; (b) a metal oxide of one or more of the metals selected from Zn, Pb, Bi, Gd, Ce, Zr, Ti, Mn, Sn, Ru, Co, Fe, Cu and Cr; (c) any compounds that can generate the metal oxides of (b) upon firing; and (d) mixtures thereof.

6. The composition of claim 5, wherein at least one of the additives comprises ZnO, or a compound that forms ZnO upon firing.

7. The composition of claim 1, wherein the glass frit is 1 to 6 wt % of the total composition.

8. The composition of claim 1, wherein the conductive material comprises Ag.

9. The composition of claim 8, wherein the Ag is 90 to 99 wt % of the solids in the composition.

10. The composition of claim 6, wherein the ZnO is 2 to 10 wt % of the total composition.

11. A method of manufacturing a semiconductor device comprising the steps of:
(a) providing a semiconductor substrate, one or more insulating films, and the composition of claim 1;
(b) applying the insulating film to the semiconductor substrate,
(c) applying the composition to the insulating film on the semiconductor substrate, and
(d) firing the semiconductor, insulating film and thick film composition.

12. The method of claim 11, wherein the insulating film comprises one or more components selected from: titanium oxide, silicon nitride, SiNx:H, silicon oxide, and silicon oxide/titanium oxide.

13. A semiconductor device made by the method of claim 11.

14. A semiconductor device comprising an electrode, wherein the electrode, prior to firing, comprises the composition of claim 1.

15. A solar cell comprising the semiconductor device of claim 14.

## Patentansprüche

1. Zusammensetzung umfassend:
(a) ein oder mehrere elektrisch leitfähige Materialien;
(b) eine oder mehrere Glasfritten, wobei eine oder mehrere der Glasfritten Folgendes umfassen, auf die Gew.-% der Glasfritte bezogen:
7 - 25 Gew.-% SiO₂,
55 - 90 Gew.-% Bi₂O₃,
0,5 - 5 Gew.-% B₂O₃,
1,5 - 8 Gew.-% eines oder mehrerer Alkalimetalloxide,
1 - 8 Gew.-% ZrO₂; und
(c) organisches Medium.

2. Zusammensetzung nach Anspruch 1, wobei eine oder mehrere der Glasfritten 11-25 Gew.-% SiO₂ umfassen.

3. Zusammensetzung nach Anspruch 1, wobei die Alkalimetalloxide aus der Gruppe ausgewählt sind bestehend aus: Na₂O, Li₂O und Mischungen davon.

4. Zusammensetzung nach Anspruch 1, wobei der Erweichungspunkt der Glasfritte 500 - 600 °C beträgt.

5. Zusammensetzung nach Anspruch 1, des Weiteren ein oder mehrere Zusatzmittel umfassend ausgewählt aus der Gruppe bestehend aus: (a) einem Metall, wobei das Metall unter Zn, Pb, Bi, Gd, Ce, Zr, Ti, Mn, Sn, Ru, Co, Fe, Cu und Cr ausgewählt ist; (b) einem Metalloxid von einem oder mehreren der Metalle ausgewählt unter Zn, Pb, Bi, Gd, Ce, Zr, Ti, Mn, Sn, Ru, Co, Fe, Cu und Cr; (c) irgendwelchen Verbindungen, die die Metalloxide von (b) auf das Brennen hin erzeugen können; und (d) Mischungen davon.

6. Zusammensetzung nach Anspruch 5, wobei mindestens eines der Zusatzmittel ZnO oder eine Verbindung, die beim Brennen ZnO bildet, umfasst.

7. Zusammensetzung nach Anspruch 1, wobei die Glasfritte 1 bis 6 Gew.-% der gesamten Zusammensetzung ausmacht.

8. Zusammensetzung nach Anspruch 1, wobei das leitfähige Material Ag umfasst.

9. Zusammensetzung nach Anspruch 8, wobei das Ag 90 bis 99 Gew.-% der Feststoffe in der Zusammensetzung ausmacht.

10. Zusammensetzung nach Anspruch 6, wobei das ZnO 2 bis 10 Gew.-% der gesamten Zusammensetzung ausmacht.

11. Verfahren für die Herstellung einer Halbleitervorrichtung, umfassend die Schritte des:
(a) Bereitstellens eines Halbleitersubstrats, einer oder mehrerer Isolierfolien und der Zusammensetzung nach Anspruch 1;
(b) Aufbringens der Isolierfolie auf das Halbleitersubstrat,
(c) Aufbringen der Zusammensetzung auf die Isolierfolie auf dem Halbleitersubstrat und
(d) Brennens des Halbleiters, der Isolierfolie und der Dickfilmzusammensetzung.

12. Verfahren nach Anspruch 11, wobei die Isolierfolie eine oder mehrere Komponenten umfasst, ausgewählt unter: Titandioxid, Siliciumnitrid, SiNx:H, Siliciumdioxid und Siliciumdioxid/Titandioxid.

13. Halbleitervorrichtung, die durch das Verfahren nach Anspruch 11 hergestellt wird.

14. Halbleitervorrichtung umfassend eine Elektrode, wobei die Elektrode vor dem Brennen die Zusammensetzung nach Anspruch 1 umfasst.

15. Solarzelle umfassend die Halbleitervorrichtung nach Anspruch 14.

## Revendications

1. Composition comprenant:
(a) un ou plusieurs matériau(x) électriquement conducteur(s);
(b) une ou plusieurs fritte(s) de verre, dans laquelle l'une ou plusieurs des frittes de verre comprend(comprennent), sur la base du % en pds de la fritte de verre.
7 à 25 % en pds de SiO₂,
55 à 90 % en pds de Bi₂O₃,
0,5 à 5 % en pds of B₂O₃,
1,5 à 8 % en pds d'un ou plusieurs oxyde(s) de métal alcalin;
1 à 8 % en pds de ZrO₂; et
(c) un milieu organique.

2. Composition selon la revendication 1, dans laquelle une ou plusieurs des frittes de verre comprend(comprennent) 11 à 25 % en pds de SiO₂.

3. Composition selon la revendication 1, dans laquelle les oxydes de métal alcalin sont sélectionnés parmi le groupe constitué de: Na₂O, Li₂O et leurs mélanges.

4. Composition selon la revendication 1, dans laquelle le point de ramollissement de la fritte de verre est de 500 à 600°C.

5. Composition selon la revendication 1, comprenant en outre un ou plusieurs additif(s) sélectionné(s) parmi le groupe constitué de: (a) un métal dans lequel ledit métal est sélectionné parmi Zn, Pb, Bi, Gd, Ce, Zr, Ti, Mn, Sn, Ru, Co, Fe, Cu, et Cr; (b) un oxyde métallique d'un ou plusieurs des métaux sélectionné(s) parmi Zn, Pb, Bi, Gd, Ce, Zr, Ti, Mn, Sn, Ru, Co, Fe, Cu et Cr; (c) n'importe quels composés qui peuvent générer les oxydes métalliques de (b) à l'issue de la calcination; et (d) leurs mélanges.

6. Composition selon la revendication 5, dans laquelle au moins l'un des additifs comprend ZnO, ou un mélange qui forme ZnO par calcination.

7. Composition selon la revendication 1, dans laquelle la fritte de verre est de 1 à 6 % en pds de la composition totale.

8. Composition selon la revendication 1, dans laquelle le matériau conducteur comprend Ag.

9. Composition selon la revendication 8, dans laquelle l'Ag est de 90 à 99 % en pds des matières solides dans la composition.

10. Composition selon la revendication 6, dans laquelle le ZnO représente 2 à 10 % en pds de la composition totale.

11. Procédé de fabrication d'un dispositif semi-conducteur comprenant les étapes de:
(a) fourniture d'un substrat semi-conducteur, d'un ou plusieurs film(s) isolant(s) et de la composition selon la revendication 1;
(b) application du film isolant au substrat semi-conducteur,
(c) application de la composition au film isolant sur le substrat semi-conducteur, et
(d) calcination du semi-conducteur, isolation du film et de la composition de film épais.

12. Procédé selon la revendication 11, dans lequel le film isolant comprend un ou plusieurs composant(s) parmi: l'oxyde de titane, le nitrure de silicium, SiNx:H, l'oxyde de silicium et l'oxyde de silicium/oxyde de titane.

13. Dispositif semi-conducteur fabriqué selon le procédé selon la revendication 11.

14. Dispositif semi-conducteur comprenant une électrode, dans lequel l'électrode, avant la calcination, comprend la composition selon la revendication 1.

15. Pile photovoltaïque comprenant le dispositif semi-conducteur selon la revendication 14.
